# EUROPÄISCHE PATENTSCHRIFT

(11) **EP 2 011 170 B1**
(45) Veröffentlichungstag und Bekanntmachung des Hinweises auf die Patenterteilung: **10.11.2010**
(21) Anmeldenummer: 07728213.5
(22) Anmeldetag: 18.04.2007
(51) Int. Cl.: H01L 41/22, H01L 41/24

(54) **VERFAHREN ZUR HERSTELLUNG EINES PIEZOAKTORS**
METHOD FOR THE PRODUCTION OF A PIEZO ACTUATOR
PROCÉDÉ DE PRODUCTION D'UN ACTIONNEUR PIÉZO

(30) Priorität: 19.04.2006 DE 102006018034
(43) Veröffentlichungstag der Anmeldung: 07.01.2009
(73) Patentinhaber: Robert Bosch GmbH, 70442 Stuttgart (DE)
(72) Erfinder: HOHMANN, Eugen, 96191 Viereth-Trunstadt (DE); HENNECK, Stefan, 71229 Leonberg (DE); FERGEN, Immanuel, 76646 Bruchsal (DE)
(86) Internationale Anmeldenummer: PCT/EP2007/053751
(87) Internationale Veröffentlichungsnummer: WO 2007/118883

(56) Entgegenhaltungen:
- EP-A2- 1 204 152
- WO-A-01/78158
- WO-A-03/073523
- DE-A1- 4 421 007
- DE-A1- 10 236 986
- DE-A1- 19 620 826
- DE-C1- 19 945 934
- JP-A- 6 232 466
- MOILANEN H ET AL: "FABRICATION OF PIEZOELECTRIC THICK-FILM LOW-VOLTAGE MULTILAYER ACTUATORS USING A NEW DOUBLE-PASTE PRINTING TECHNIQUE" SENSORS AND ACTUATORS A, ELSEVIER SEQUOIA S.A., LAUSANNE, CH, Bd. A37/38, 1. Juni 1993 (1993-06-01), Seiten 106-111, XP000411382 ISSN: 0924-4247

## Beschreibung

### Stand der Technik

Die Erfindung geht von einem Piezoaktor aus, wie er beispielsweise aus der Offenlegungsschrift DE 199 28 189 A1 bekannt ist. Ein solcher Piezoaktor ist als Multilayeraktor ausgebildet, das heißt, er besteht aus einer Vielzahl von piezoaktiven keramischen Schichten. Zwischen diesen Schichten sind metallische Innenelektroden flächenartig ausgebildet, die wechselseitig in einen Bereich der Oberfläche geführt sind. Dort sind die Innenelektroden mit wenigstens zwei Außenelektroden kontaktiert, durch die eine elektrische Spannung so an die Innenelektroden angelegt werden kann, dass zwischen jeweils benachbarten Innenelektroden ein elektrisches Feld entsteht, das die piezoaktiven Schichten durchsetzt. Je nach Stärke des elektrischen Feldes, also je nach Höhe und Polarität der angelegten elektrischen Spannung, ändert sich die Dicke der piezokeramischen Schichten, was eine Längenänderung des Piezoaktors als Ganzes bewirkt.

Die Außenelektroden bestehen hierbei aus einer Grundmetallisierung, die direkt auf den Piezoaktor aufgebracht ist, und einer meist netz- oder gewebeartigen, flexiblen Metallelektrode, die mit der Grundmetallisierung verlötet wird. Der Grund hierfür ist, dass durch die Längenänderung des Piezoaktors die direkt aufgebrachte Grundmetallisierung einreißen kann, so dass eine durchgängige Einleitung der elektrischen Spannung in die Innenelektroden nicht mehr gewährleistet wäre. Durch die flexible Metallelektrode, die an verschiedenen Punkten mit der Grundmetallisierung verbunden ist, wird die elektrische Spannung jedoch auch dann, wenn Risse in der Grundmetallisierung auftreten, eingeleitet, so dass sämtliche Innenelektroden mit der jeweiligen elektrischen Spannung versorgt werden.

Bei der Herstellung des Piezoaktors werden zunächst sogenannte Grünfolien gestapelt, bis ein Piezostapel mit der gewünschten Anzahl von Piezoschichten und zugehörigen Innenelektroden gebildet ist. Der Piezostapel wird anschließend gesintert, so dass sich eine harte Keramik ausbildet. Zur Aufbringung der Grundmetallisierung muss zuvor die so genannte Sinterhaut entfernt werden, die sich durch den Sinterprozess auf der Oberfläche des Piezostapels bildet. Wird diese herstellungsbedingte, elektrisch isolierende Schicht nicht entfernt, so wäre eine elektrische Kontaktierung der Innenelektroden nicht oder nur ungenügend möglich. Nach dem Entfernen der Sinterhaut wird die flächige Grundmetallisierung aufgebracht. Dies kann mit unterschiedlichen Verfahren realisiert werden, wie zum Beispiel Sputtern, galvanischer Abscheidung oder Aufdrucken und Einbrennen einer Metallisierungspaste, wobei das Letztere das prozesstechnisch Günstigste ist.

Als Metallbestandteil für die Grundmetallisierung kommt vorwiegend Silber oder eine Silber-Palladium-Legierung zum Einsatz. Der Metallisierungspaste werden zusätzlich noch andere Stoffe beigemischt, die als Haftvermittler dienen und ohne die eine sichere Verbindung zwischen der fertig gesinterten Piezokeramik und der Grundmetallisierung nicht möglich wäre. Nach dem Einbrennen der so erhaltenen Grundmetallisierung wird üblicherweise die flexible Metallelektrode durch Löten aufgebracht. Dies ist jedoch ein zusätzlicher, kostenintensiver und schwieriger Prozess-Schritt, da nach dem Lötprozess ein intensiver Reinigungsprozess mit organischen Lösemitteln notwendig ist, um die Flussmittelreste zu entfernen. Dies verteuert den Piezoaktor und damit seine Anwendungsmöglichkeiten im Bereich der Dieseldirekteinspritzung.

Weitere Piezoaktoren und Verfahren zu ihrer Herstellung sind aus DE 102 36 986 A1, JP 6-232466 A, DE 199 45 934 C1, DE 44 21 007 A1 und H. Moilanen et al., "Fabrication of piezoelectric thick-film low-voltage multilayer actuators using a new double-paste printing technique", Sensors and Actuators - A Physical, vol. A37-A38, p. 106-111, (1993) bekannt.

### Offenbarung der Erfindung

### Vorteile der Erfindung

Das erfindungsgemäße Verfahren zur Herstellung eines Piezoaktors, der eine Vielzahl von piezoaktiven Keramikschichten und entsprechende metallische Innenelektroden aufweist, hat demgegenüber den Vorteil, dass die Grundmetallisierung und die flexible Metallelektrode durch einen einzigen Prozess-Schritt mit dem Piezostapel verbunden werden. In einem nicht erfindungsgemäßen Verfahren wird der Piezostapel aus Grünfolie gebildet und anschließend gesintert. Der gesinterte Piezostapel wird abgeschliffen und auf die abgeschliffenen Teile die Grundmetallisierung in einer ersten Schicht aufgebracht. Nach dem Trocknen der ersten Schicht wird eine zweite Schicht aufgebracht, auf die, solange die zweite Schicht noch flüssig ist, die flexible Metallelektrode aufgesetzt wird. Anschließend wird der Piezoaktor gebrannt, so dass sich einerseits die zweite Schicht der Grundmetallisierung mit der ersten Schicht und andererseits die flexible Metallelektrode mit der Grundmetallisierung verbinden.

Bei dem erfindungsgemäßen Verfahren wird bereits auf den Grünkörper, also auf den durch die Grünfolie gebildeten Piezostapel, die erste Schicht der Grundmetallisierung aufgebracht. Anschließend wird der Grünkörper gesintert, so dass eine harte Keramik entsteht, wobei sich die erste Schicht der Grundmetallisierung bereits mit der Oberfläche des Piezostapels verbindet. Durch diese Grundmetallisierung wird die Ausbildung einer Sinterhaut an dieser Stelle verhindert, so dass das anschließende Abschleifen des Piezoaktors entfällt. Anschließend wird eine zweite Schicht der Metallisierungspaste aufgebracht, die die zweite Schicht der Grundmetallisierung bildet. Auf diese Nass-Schicht wird wiederum die flexible Außenelektrode aufgesetzt und nach dem Trocknen der Nass-Schicht durch einen Brennprozess die flexible Metallelektrode mit der Grundmetallisierung verbunden.

In vorteilhaften Weiterbildungen des erfindungsgemäßen Verfahrens erfolgt das Brennen bei einer Temperatur von vorzugsweise mehr als 300 °C. Dies geschieht vorzugsweise unter Schutzgas, wie Stickstoff, Argon oder einem anderen Edelgas, so dass eine Oxidation der Metallelektrode verhindert wird. Ist die Metallisierungspaste, die die Grundmetallisierung bildet, beim Auflegen der flexiblen Außenelektrode flüssig, so bildet sich an den Auflagepunkten der flexiblen Metallelektrode ein Meniskus, so dass nach dem Brennen eine mechanisch belastbare und elektrisch gut leitende Verbindung zwischen der flexiblen Metallelektrode und der Grundmetallisierung entsteht.

In einer weiteren vorteilhaften Weiterbildung des erfindungsgemäßen Verfahrens wird die zweite Schicht der Grundmetallisierung nur auf 20 bis 80 %, vorzugsweise auf 30 bis 70 %, der ersten Schicht aufgebracht. Diese zweite Schicht wird vorzugsweise in parallelen Streifen aufgebracht, die zur Ebene senkrecht zur Dehnungsrichtung des Piezostapels verkippt sind. Dies hat den Vorteil, das Bereiche entstehen, die eine relativ große Schichtdicke der Grundmetallisierung aufweisen und dementsprechend von Rissen in der Grundmetallisierung weniger betroffen sind. Treten Risse in der Grundmetallisierung auf, so geschieht dies vorzugsweise genau parallel zu den piezoaktiven Schichten, wobei sich diese Risse in die erste Schicht der Grundmetallisierung fortsetzen und dort zu einer Unterbrechung der metallischen Verbindung und damit der elektrischen Leitung führen. Durch die Streifen der zweiten Schicht, die mit der flexiblen Metallelektrode verbunden sind, wird jedoch die elektrische Spannung in alle Bereiche der Grundmetallisierung geleitet, was durch den eingeschlossenen Winkel zwischen den parallelen Streifen der zweiten Schicht und der Ebene senkrecht zur Dehnungsrichtung des Piezostapels gewährleistet wird.

Bei dem nach dem erfindungsgemäßen Verfahren hergestellten Piezoaktor ist die flexible Metallelektrode in die Grundmetallisierung eingebrannt, so dass der sonst übliche Lötprozess entfallen kann.

Die flexible Metallelektrode ist vorzugsweise so ausgebildet, dass sie durch das Einbrennen nur mit der zweiten Schicht der Grundmetallisierung verbunden wird. Das bereits beim erfindungsgemäßen Verfahren erwähnte Muster der zweiten Schicht der Grundmetallisierung in Form von Streifen ist auch hier besonders vorteilhaft. Um eine gute elektrische Verbindung zwischen der flexiblen Metallelektrode und der Grundmetallisierung zu erreichen, ist es besonders vorteilhaft, eine Metallelektrode aus Invar zu verwenden, die versilbert ist. Invar ist eine Metalliegierung, die eine besonders geringe Wärmeausdehnung aufweist und damit etwa dieselbe wie die Piezokeramik. Hierdurch kommt es zu geringen mechanischen Spannungen durch Temperaturschwankungen, denen der Piezoaktor beim Einsatz in einer Brennkraftmaschine zwangsläufig ausgesetzt ist. Durch die Versilberung des Invars ist eine gute Verbindung zwischen der flexiblen Metallelektrode und der Grundmetallisierung, die vorzugsweise aus Silber oder einer Silber-Palladium-Legierung besteht, gewährleistet.

### Zeichnung

In der Zeichnung sind ein Piezoaktor und verschiedene Prozess-Schritte des erfindungsgemäßen Verfahrens zu seiner Herstellung dargestellt. Es zeigt
- Figur 1: schematisch einen Piezoaktor in einer Aufsicht,
- Figur 2: eine Seitenansicht des Piezoaktors bei einem ersten Prozess-Schritt,
- Figuren 3, 4 und 5: die darauf folgenden Prozess-Schritte bei der Herstellung des Piezoaktors nach dem erfindungsgemäßen Verfahren und
- Figur 6: einen Querschnitt durch einen Piezoaktor.

### Ausführungsformen der Erfindung

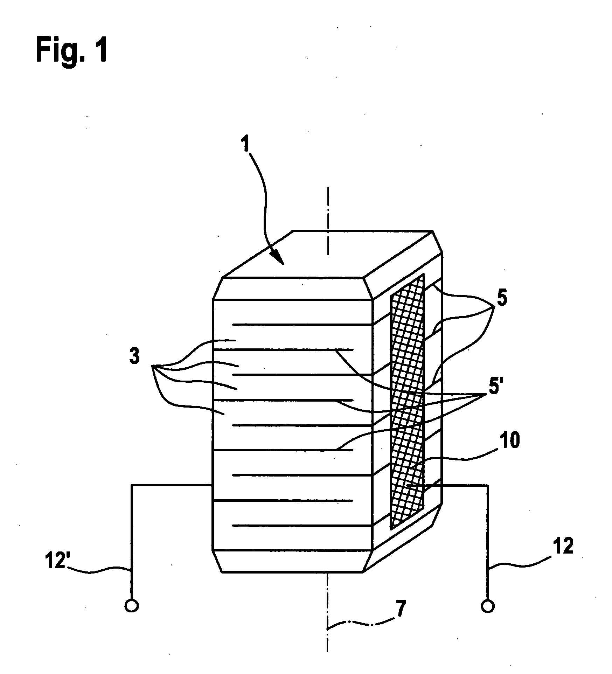

In **Figur 1** ist ein Piezoaktor in einer perspektivischen Ansicht schematisch dargestellt. Der Piezoaktor weist einen Piezostapel 1 auf, der aus einer Vielzahl von Piezoschichten 3 besteht. Der Deutlichkeit halber sind in Figur 1 nur wenige Piezoschichten 3 dargestellt. Tatsächlich verwendete Piezoaktoren weisen meist 100 bis 200 solcher Piezoschichten 3 auf. Zwischen jeweils zwei Piezoschichten befindet sich eine metallische Innenelektrode 5 bzw. 5', die abwechselnd auf eine Seite des Piezostapels geführt sind. Jeweils eine Hälfte der Innenelektroden 5, 5' wird von einer Außenelektrode 10, 10' elektrisch kontaktiert, die auf die Oberfläche des Piezostapels 1 aufgebracht ist. Die Außenelektrode 10 besteht aus einer Grundmetallisierung 20, die direkt auf die Oberfläche des Piezostapels 1 aufgebracht ist, und einer sieb- oder netzartigen flexiblen Metallelektrode 25, die mit der Grundmetallisierung 20 verbunden ist. Die flexible Metallelektrode 25 ist schließlich mit einem elektrischen Anschluss 12, 12' verbunden, über welche eine elektrische Spannung angelegt werden kann.

Durch das Anlegen der elektrischen Spannung zwischen den elektrischen Anschlüssen 12, 12' entsteht ein elektrisches Feld zwischen den Innenelektroden 5, die auf einer Seite des Piezostapels 1 nach außen geführt sind, und der anderen Hälfte der Innenelektroden 5', die an der gegenüberliegenden Seite des Piezostapels 1 bis zur Oberfläche geführt sind. Zwischen den Innenelektroden 5, 5' ergibt sich so ein relativ homogenes elektrisches Feld, das die Piezoschichten 3 durchdringt. Je nach Stärke und Polarität dieses elektrischen Feldes kommt es zu einer Dickenänderung der Piezoschichten 3 und damit insgesamt zu einer Längenänderung des Piezostapels 1. Der Piezostapel 1 dehnt sich oder zieht sich zusammen entlang einer Dehnungsachse 7, wobei die Richtung der Dehnungsachse 7 über die Polarisationsrichtung der Piezokeramiken festgelegt wird.

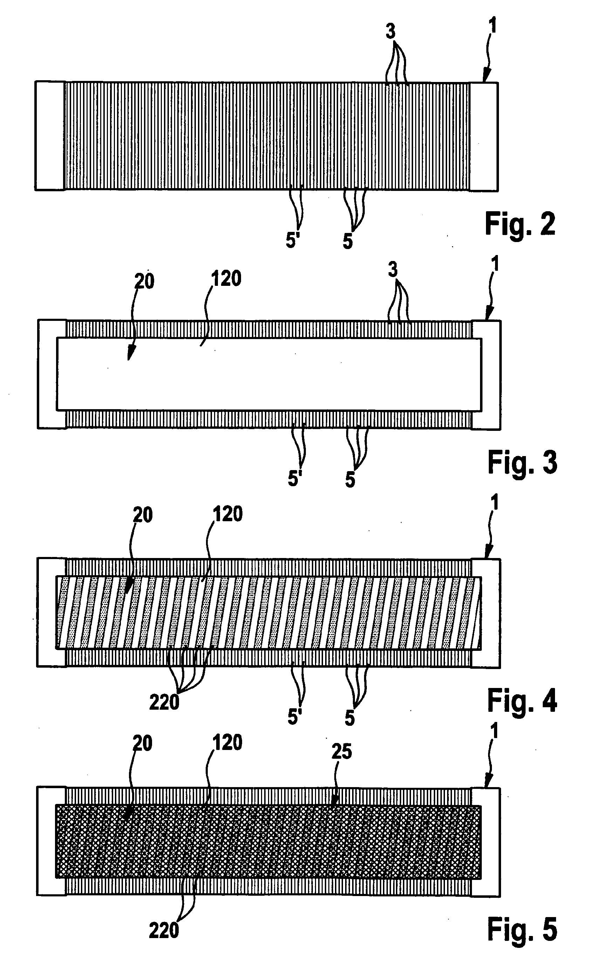

Die Herstellung des Piezoaktors geschieht nach folgendem Verfahren: zur Bildung des Piezoaktors wird Grünfolie gestapelt und laminiert. Die Grünfolie besteht aus einem piezokeramischen Pulver mit einem polymeren Bindergemisch, das mit einer metallischen Druckschicht versehen ist, so dass ein Stapel mit abwechselnd piezokeramischen Schichten und Metallelektroden entsteht, der sogenannte Grünkörper. Anschließend wird der Grünkörper entbindert und gesintert, also bei hohen Temperaturen gebrannt, so dass sich der organische Polymerbinder verflüchtigt und das Keramikpulver in einer feste, verdichtete Keramik umbildet, die letztendlich piezoaktiv ist. **Figur 2** zeigt hierzu eine Draufsicht auf den so entstandenen Piezostapel 1, bei dem die Anordnung der Piezoschichten 3 und der Innenelektroden 5 bzw. 5' deutlich wird. Bei Piezoaktoren, wie sie in Kraftstoffeinspritzanlagen verwendet werden, sind häufig mehr als zweihundert Piezoschichten 3 üblich. Die Schichtdicke der einzelnen Piezoschichten 3 beträgt etwa 0,1 mm, während die Innenelektroden 5, 5' eine Schichtdicke von nur wenigen µm aufweisen.

Zum Aufbringen der Grundmetallisierung wird der Piezostapel 1 nach dem Sintern abgeschliffen, um die Sinterhaut zu entfernen, was ansonsten einen elektrischen Kontakt zu den Innenelektroden 5, 5' erschweren oder unmöglich machen würde. Anschließend wird eine Metallisierungspaste aufgebracht, die eine erste Schicht 120 der Grundmetallisierung 20 bildet. **Figur 3** zeigt hierzu diese erste Schicht 120 der Grundmetallisierung 20, die vollflächig eine Seite des Piezostapels 1 bedeckt. Die Metallisierungspaste ist beim Auftragen flüssig, so dass vor den weiteren Prozess-Schritten abgewartet wird, bis diese erste Schicht 120 getrocknet ist. Anschließend wird eine zweite Schicht 220 der Grundmetallisierung 20 aufgebracht, wie in **Figur 4** dargestellt. Diese zweite Schicht 220 wird in Streifen aufgebracht, die schräg zur Dehnungsachse 7 des Piezostapels 1 geneigt sind. Die zweite Schicht der Grundmetallisierung 20 bedeckt hierbei 20 bis 80 % der ersten Schicht 120, vorzugsweise 30 bis 70 %.

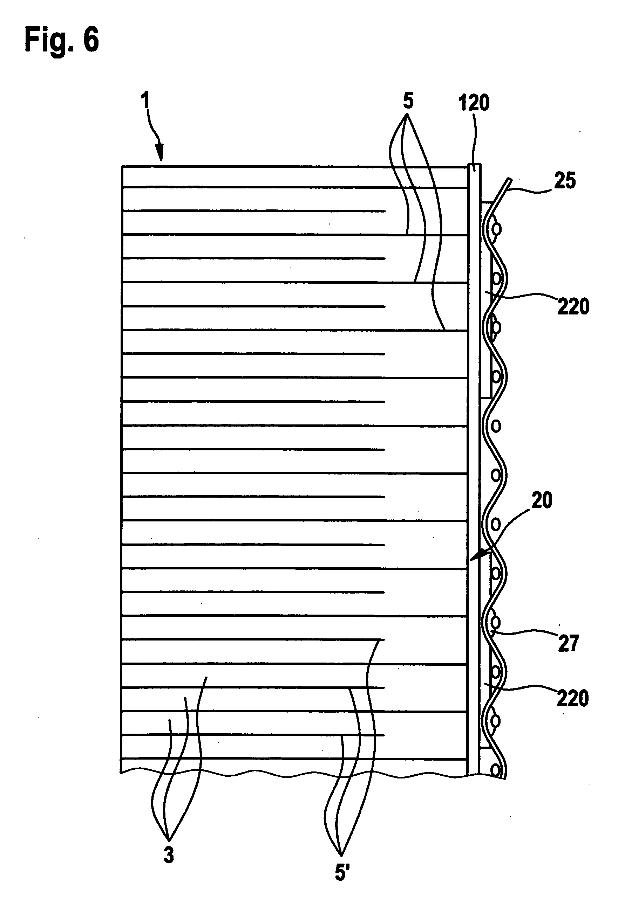

Im nächsten Prozess-Schritt wird eine flexible Metallelektrode 25 in die noch flüssige zweite Schicht 220 der Grundmetallisierung 20 aufgesetzt, wie in **Figur 5** dargestellt. Die flexible Metallelektrode 25 kann hierbei netz- oder siebartig aus Draht gebildet sein, vorzugsweise aus Invardraht, da dieser eine geringe thermische Dehnung aufweist, die ähnlich der von Keramik ist. Da die zweite Schicht 220 der Grundmetallisierung 20 noch flüssig ist, bildet sich an den Berührpunkten der flexiblen Metallelektrode ein Meniskus 27, der eine gute elektrische Verbindung der flexiblen Metallelektrode 25 zur zweiten Schicht 220 der Grundmetallisierung 20 herstellt. **Figur 6** zeigt hierzu einen Querschnitt durch den Piezostapel 1, bei dem dieser Effekt verdeutlicht ist.

Durch das Aufbringen der zweiten Schicht 220 der Grundmetallisierung 20 in Streifen kommt es nur an diesen Stellen zum elektrischen Kontakt zwischen der flexiblen Metallelektrode 25 und der Grundmetallisierung 20. Die flexible Metallelektrode 25 und die Grundmetallisierung 20 bilden zusammen die Außenelektroden 10, 10'. Um die Außenelektroden 10, 10' zu fixieren, wird der Piezostapel 1 anschließend gebrannt, so dass sich die flexible Metallelektrode 25 mit der Metallisierungspaste und diese wiederum fest mit dem Piezostapel 1 verbindet. Der dadurch gebildete Piezoaktor kann dann mit Anschlusselektroden 12, 12' versehen werden und ist damit fertig gestellt.

Die Metallisierungspaste, aus der die Grundmetallisierung 20 gebildet wird, besteht vorzugsweise aus Silber oder einer Silber-Palladium-Legierung, der noch blei- oder wismuthaltige Glasfritten, Wismutoxid und/oder bleifreies Glaspulver als Haftvermittler beigemischt sind. Diese Beimischungen sind notwendig, um eine feste Verbindung mit der fertig gesinterten Piezokeramik herzustellen, die anderweitig nicht gegeben wäre. Damit die flexible Metallelektrode 25 mechanisch und elektrisch eine gute Verbindung zur Grundmetallisierung 20 aufweist, hat sich Invardraht bewährt, der mit einer Silberschicht überzogen ist.

Bei der erfindungsgemäßen Herstellungsmethode des Piezostapels 1 wird die erste Schicht 120 der Grundmetallisierung 20 bereits vor dem Sintern auf den Grünkörper aufgebracht. Anschließend wird der Grünkörper gesintert, so dass sich der Piezostapel 1 bildet, der bereits die erste Schicht 120 der Grundmetallisierung 20 aufweist, welche die Bildung der Sinterhaut in diesem Bereich unterdrückt. Anschließend wird, wie oben beschrieben und in Figur 4 gezeigt, die zweite Schicht 220 der Grundmetallisierung 20 aufgebracht. Nach dem Aufbringen der flexiblen Metallelektrode 25 erfolgt wiederum ein Brennvorgang, um die zweite Schicht 220 der Grundmetallisierung 20 mit der ersten Schicht und die flexible Metallelektrode 25 mit der Grundmetallisierung 20 fest zu verbinden.

Besteht die flexible Metallelektrode 25 aus einem Invardraht, so findet vorzugsweise Draht mit einem Drahtdurchmesser von 50 bis 100 µm Anwendung. Wird eine Metallisierungspaste verwendet, die aus Silber oder einer silberhaltigen Legierung besteht, so ist die Verwendung eines versilberten Invardraht vorteilhaft, da hierdurch die elektrische und mechanische Verbindung zwischen Draht und Grundmetallisierung 20 verbessert wird. Soll eine Metallisierungspaste verwendet werden, deren Basis Kupfer ist, so kann der Invardraht entsprechend mit Kupfer beschichtet werden.

Das Aufbringen der Grundmetallisierung 20 in Form einer Metallpaste kann beispielsweise durch Bedrucken geschehen, etwa im Siebdruckverfahren, oder auch durch Tampondruck oder mit einer anderen geeigneten Technik.

Das Einbrennen der Metallisierungspaste zur Bildung der Grundmetallisierung 20 erfolgt vorzugsweise unter Schutzgasatmosphäre, also zum Beispiel unter Stickstoff- oder Argonatmosphäre, wobei auch andere Edelgase in Frage kommen. Dies erfordert eine Metallisierungspaste auf Basis eines leicht depolymerisierbaren Binders. Hierzu bieten sich Polymethacrylate als besonders geeignet an. Neben dem Metallpulver, zum Beispiel Silber, Silber-Palladium, Kupfer, Nickel oder einer Mischung derselben, dem Acrylatbinder sowie Lösungsmitteln enthält die Metallisierungspaste noch ein Glaspulver. Dieses Glas ist ein vorzugsweise bleifreies Aluminiumoxid-(Al₂O₃)-haltiges Alkali-Erdalkali-Borsilicat mit hohem SiO₂-Anteil von größer 50 %, welches auf eine Körnung im Bereich von d₅₀ (5 bis 10 µm) und d₉₉ (bis 35 µm) vermahlen ist und zwischen 2 und 20 Vol.-% der anorganischen Feststoffe der Paste darstellt.

Wird die Metallisierungspaste bereits vor dem Sintern aufgebracht, so ist eine auf das Sinterverhalten in der Keramik, also zum Beispiel der PZT-Keramik, abgestimmte Silber- oder Silber-Palladium-Paste notwendig, die kein Glas, aber eine geringe Menge an Keramik- bzw. Metalloxid-Pulver (ZrO₂, TiO₂) enthält. Bei Aktoren mit Kupferinnenelektroden ist auch eine Variante mit Kupferpaste denkbar. Die Metallisierungspaste, die für die zweite Schicht 220 der Grundmetallisierung 20 verwendet wird, benötigt hier nicht unbedingt einen Glasanteil, da nur Metalloberflächen mit Metall aus der Metallisierungspaste versintert werden müssen.

Der nach dem erfindungsgemäßen Verfahren hergestellte Piezoaktor weist also den Vorteil auf, dass er mit relativ wenigen, kostengünstigen Prozess-Schritten herzustellen ist. Anders als beim Auflöten der flexiblen Metallelektrode 25 entfallen aufwendige Reinigungsprozesse, die den Piezoaktor deutlich verteuern. Der Piezoaktor kann ohne weitere Behandlung den folgenden Prozess-Schritten zugeführt werden.

## Patentansprüche

1. Verfahren zur Herstellung eines Piezoaktors mit einer Vielzahl von Piezoschichten (3), zwischen denen jeweils eine metallische Innenelektrode (5, 5') angeordnet ist, so dass ein Piezostapel (1) gebildet wird, wobei die Innenelektroden (5, 5') abwechselnd an verschiedene Teilflächen der Oberfläche des Piezostapels (1) geführt sind, **gekennzeichnet durch** folgende Verfahrensschritte:
- Aufbringen einer ersten Schicht einer Metallisierungspaste auf einen Teil der Oberfläche des ungesinterten Piezostapels (1) (Grünkörper),
- Sintern des Piezostapels (1), wobei sich die erste Schicht Metallisierungspaste mit der Oberfläche des Piezostapels (1) verbindet und so eine erste Schicht (120) einer Grundmetallisierung (20) bildet, die eine elektrische Verbindung zu einem Teil der Innenelektroden (5, 5') herstellt,
- Aufbringen einer weiteren Schicht Metallisierungspaste auf die erste Schicht (120) der Grundmetallisierung (20),
- Aufsetzen einer flexiblen Metallelektrode (25) auf die weitere Schicht Metallisierungspaste,
- Brennen des Piezoaktors, so dass die weitere Schicht Metallisierungspaste eine zweite Schicht (220) der Grundmetallisierung (20) bildet, wobei die flexible Metallelektrode (25) mit der Grundmetallisierung (20) stoffschlüssig verbunden wird.

2. Verfahren nach Anspruch 1, **dadurch gekennzeichnet, dass** die Metallisierungspaste beim Aufbringen auf den Piezostapel (1) flüssig ist.

3. Verfahren nach Anspruch 1 oder 2, **dadurch gekennzeichnet, dass** das Brennen des Piezostapel (1) bei einer Temperatur von mehr als 300 °C erfolgt, vorzugsweise bei 700 bis 800 °C.

4. Verfahren nach Anspruch 3, **dadurch gekennzeichnet, dass** das Brennen unter Schutzgas erfolgt, das eine Oxidation der Grundmetallisierung (20) oder der flexiblen Metallelektrode (25) ver-5 hindert.

5. Verfahren nach Anspruch 4, **dadurch gekennzeichnet, dass** das Schutzgas Stickstoff, Argon oder ein anderes Edelgas ist.

6. Verfahren nach Anspruch 1, **dadurch gekennzeichnet, dass** die zweite Schicht (220) der Grundmetallisierung (20) 20 bis 80 %, vorzugsweise 30 bis 70 % der ersten Schicht (120) bedeckt.

7. Verfahren nach Anspruch 1 oder 6, **dadurch gekennzeichnet, dass** die zweite Schicht (220) der Grundmetallisierung (20) in parallelen Streifen aufgebracht wird.

8. Verfahren nach Anspruch 7, **dadurch gekennzeichnet, dass** der Piezostapel eine Dehnungsrichtung (7) aufweist und dass die Streifen der zweiten Schicht (220) der Grundmetallisierung (20) zu einer Ebene senkrecht zur Dehnungsrichtung (7) verkippt sind.

9. Verfahren nach Anspruch 1, 6, 7 oder 8, **dadurch gekennzeichnet, dass** die flexible Metallelektrode (25) auf die die zweite Schicht (220) der Grundmetallisierung (20) bildende Metallisierungspaste aufgesetzt wird, solange diese noch flüssig ist.

## Claims

1. Method for the production of a piezo actuator, having a multiplicity of piezo layers (3) between each of which there is a metallic inner electrode (5, 5'), such that a piezo stack (1) is formed, wherein the inner electrodes (5, 5') are guided alternately on different subareas of the surface of the piezo stack (1), **characterized by** the following method steps:
- a first layer of a metallization paste is applied to part of the surface of the unsintered piezo stack (1) (green body),
- the piezo stack (1) is sintered, wherein the first layer of metallization paste bonds to the surface of the piezo stack (1) and a first layer (120) of a base metallization (20) is thereby formed, which produces an electrical connection to part of the inner electrodes (5, 5'),
- a further layer of metallization paste is applied to the first layer (120) of the base metallization (20),
- a flexible metal electrode (25) is placed on the further layer of metallization paste,
- the piezo actuator is fired, such that the further layer of metallization paste forms a second layer (220) of the base metallization (20), wherein the flexible metal electrode (25) is integrally bonded to the base metallization (20).

2. Method according to Claim 1, **characterized in that** the metallization paste is in liquid form when applied to the piezo stack (1).

3. Method according to Claim 1 or 2, **characterized in that** the piezo stack (1) is fired at a temperature of more than 300°C, preferably at 700 to 800°C.

4. Method according to Claim 3, **characterized in that** the piezo stack is fired under protective gas, which prevents oxidation of the base metallization (20) or of the flexible metal electrode (25).

5. Method according to Claim 4, **characterized in that** the protective gas is nitrogen, argon or another noble gas.

6. Method according to Claim 1, **characterized in that** the second layer (220) of the base metallization (20) covers 20 to 80%, preferably 30 to 70%, of the first layer (120).

7. Method according to Claim 1 or 6, **characterized in that** the second layer (220) of the base metallization (20) is applied in parallel strips.

8. Method according to Claim 7, **characterized in that** the piezo stack has an extension direction (7) and **in that** the strips of the second layer (220) of the base metallization (20) are tilted in relation to a plane perpendicular to the extension direction (7).

9. Method according to Claim 1, 6, 7 or 8, **characterized in that** the flexible metal electrode (25) is placed on the metallization paste which forms the second layer (220) of the base metallization (20), as long as said paste is still in liquid form.

## Revendications

1. Procédé de fabrication d'un piézoactionneur doté de plusieurs couches piézoélectriques (3) entre chacune desquelles est disposée une électrode intérieure métallique (5, 5') de manière à former une pile piézoélectrique (1), les électrodes intérieures (5, 5') étant placées en alternance sur des parties différentes de la surface de la pile piézoélectrique (1), **caractérisé par** les étapes de procédé suivantes :
- application d'une première couche de pâte de métallisation sur une partie de la surface de la pile piézoélectrique (1) non frittée (corps cru),
- frittage de la pile piézoélectrique (1), la première couche reliant la pâte de métallisation à la surface de la pile piézoélectrique (1) et formant ainsi une première couche (120) de métallisation de base (20) qui établit une liaison électrique avec une partie des électrodes intérieures (5, 5'),
- application d'une autre couche de pâte de métallisation sur la première couche (120) de métallisation de base (20),
- application d'une électrode métallique flexible (25) sur l'autre couche de pâte de métallisation,
- cuisson du piézoactionneur de telle sorte que l'autre couche de pâte de métallisation forme une deuxième couche (220) de la métallisation de base (20), l'électrode métallique flexible (25) étant reliée en correspondance de matière à la métallisation de base (20).

2. Procédé selon la revendication 1, **caractérisé en ce que** la pâte de métallisation est liquide lorsqu'elle est appliquée sur la pile piézoélectrique (1).

3. Procédé selon les revendications 1 ou 2, **caractérisé en ce que** la cuisson de la pile piézoélectrique (1) s'effectue à une température de plus de 300°C et de préférence entre 700 et 800°C.

4. Procédé selon la revendication 3, **caractérisé en ce que** la cuisson a lieu sous un gaz de protection qui empêche l'oxydation de la métallisation de base (20) ou de l'électrode métallique flexible (25).

5. Procédé selon la revendication 4, **caractérisé en ce que** le gaz de protection est l'azote, l'argon ou un autre gaz rare.

6. Procédé selon la revendication 1, **caractérisé en ce que** la deuxième couche (220) de la métallisation de base (20) couvre de 20 à 80 % et de préférence de 30 à 70 % de la première couche (120).

7. Procédé selon les revendications 1 ou 6, **caractérisé en ce que** la deuxième couche (220) de la métallisation de base (20) est appliquée en bandes parallèles.

8. Procédé selon la revendication 7, **caractérisé en ce que** la pile piézoélectrique présente une direction de dilatation (7) et **en ce que** les bandes de la deuxième couche (220) de la métallisation de base (20) sont inclinées dans un plan perpendiculaire à la direction de dilatation (7).

9. Procédé selon les revendications 1, 6, 7 ou 8, **caractérisé en ce que** l'électrode métallique flexible (25) est appliquée sur la deuxième couche (220) de la pâte de métallisation qui forme la métallisation de base (20) pendant que cette pâte de métallisation est encore liquide.
